# EUROPEAN PATENT APPLICATION

(11) **EP 4 557 319 A1**
(43) Date of publication of application: **21.05.2025**
(21) Application number: 23210185.7
(22) Date of filing: 15.11.2023
(51) Int. Cl.: H01C 1/14, H01C 3/10, G01R 15/04, H01C 3/20, H01C 7/22, H01C 3/12, H01C 1/148

(54) **RESISTOR STRUCTURE AND A VOLTAGE DIVIDER ARRANGEMENT**

(71) Applicant: ABB SCHWEIZ AG, 5400 Baden (CH)
(72) Inventor: HOZOI, Adrian, 68219 Mannheim (DE); SOMMER, Felix, 64285 Darmstadt (DE); MIGUNOV, Vadim, 68526 Ladenburg (DE); PAVLAS, Marek, 683 54 Otnice (CZ)
(74) Representative: Maiwald GmbH

(57) **Abstract**

The invention relates to a resistor structure comprising at least an electrically insulating substrate, at least one electrically conductive terminal directly or indirectly provided on the substrate, at least one resistive path comprising at least one resistive trace directly or indirectly provided on the substrate and directly or indirectly joined to the terminal, wherein a thickness of the resistive trace is the thickness of the resistive trace in the thickness direction facing away from the substrate, characterized in that at least one insulator element is applied directly or indirectly and at least partially on the substrate , wherein a thickness of the insulator element is the thickness of the insulator element in the thickness direction facing away from the substrate.

## Description

### Field of the invention

The present invention concerns a resistor structure and a voltage divider arrangement as well as electric devices comprising such resistor structure and/or voltage divider arrangement.

### Background

Resistor structures and voltage divider arrangements are configured for high voltage applications, for example between 500 V and 1000 kV. Resistors which are employed at high voltages feature a high resistance to limit power dissipation, e.g. larger than 100 kΩ.

Resistor structures may comprise an electrically insulating substrate, at least one electrically conductive terminal applied on the substrate, and at least one resistive path applied on the substrate and joined to the terminal.

A voltage divider arrangement may, in its simplest embodiment, comprise two resistor structures electrically connected in series for transforming a high voltage, so-called primary voltage, to a lower voltage, so-called secondary voltage. The secondary voltage is significantly smaller than the primary voltage, e.g. by a voltage divider ratio between 10 to 100 000. In more complex embodiments of a voltage divider, one or both of the serial resistor structures may be replaced by resistive networks. The resistors or corresponding resistor networks may be referred to as high and low ohmic resistors, respectively.

These devices may be integrated in electrical devices, in which in particular severe operating conditions such as strong voltage overloads, power overloads, temperature variations, humidity variations, mechanical stresses and shocks may occur. Example electric devices are electronic instrument transformers (sensors), such as the KEVCD and KEVA sensor types of ABB, which are commonly employed in electrical power systems with a rated primary voltage between 7.2 kV and 48 kV.

US 9, 299, 484 B2, the contents of which is incorporated, discloses a resistive structure as well as a resistive voltage divider arrangement.

High voltage applications typically require particular engineering efforts, to ensure both functionality and safety. The reason is that such resistor structures are exposed to a high electric field intensity, typically imposing excessive electric stresses. This may result in dielectric failures, like partial discharge or electrical breakdown.

Therefore, it is desired to improve resistor structures and voltage divider arrangements as to manufacture, reliability and safety.

### Summary

The inventions relates to a resistor structure comprising at least an electrically insulating substrate, at least one, preferably two electrically conductive terminals directly or indirectly provided on the substrate, at least one resistive path comprising at least one resistive trace (optionally in parts) directly or indirectly provided on the substrate and directly or indirectly joined to the terminal, wherein a thickness of the resistive trace is the thickness of the resistive trace in the thickness direction facing away from the substrate. At least one insulator element is directly or indirectly applied on a part of the substrate, wherein a thickness of the insulator element is the thickness of the insulator element in the thickness direction facing away from the substrate, and at least a part of the insulator element and a part of the resistive path/trace are arranged at least partially adjacent to each other and such that
(a) if the resistive trace/path is substantially free of a coating of a thickness between 1 µm and 200 µm, preferably 1 and 100 µm, optionally substantially free of any coating, the thickness of the insulator element is at least 30% of the thickness of the resistive trace/path, optionally larger than the thickness of the resistive trace/path,
   and/or
(b) if the resistive trace/path is substantially covered by an insulating coating having a thickness between 1 µm and 200 µm, preferably 1 and 100 µm, a total thickness of the insulator element and the insulating coating exceeds the thickness of the insulating coating on the resistive trace, optionally by at least 30%.

The present invention may alternatively or additionally be characterized as follows, see (a) above: The thickness of the insulator element is larger than a specific percentage of the thickness of the resistive trace, where at least 50% of the width of the trace is not covered by the insulator element.

The present invention may alternatively or additionally be characterized as follows, see (b) above: The thickness of the insulator element (or film) aside the resistive trace is larger than the thickness of the insulator element atop the resistive trace by at least the specific percentage of the thickness of the resistive trace.

The specific percentage of the thickness of the resistive trace may be at least 30%, preferably at least 50%, and more preferably at least 100%.

According to the invention, an electrically insulating, i.e. insulator element is provided. The insulator element is provided adjacent, i.e. next, to at least a part of the resistive trace or path. The insulator element and the resistive trace are at least partially next to each other, when viewed along the surface of the substrate.

An insulator element of the invention may be regarded as filling at least partially gaps or voids next to resistive traces with additional insulating material.

If the resistive trace is substantially not covered by a coating and/or insulation, the trace can be seen as substantially free of coating. This does not exclude that edge portions of the resistive trace are overlapped by insulation, such as a part of the insulator element. For example, insulator elements/coatings may not join each other on top of a resistive trace, if the resistive trace is substantially not covered by a coating and/or insulation.

In some embodiments, the resistive path may be seen as sunk below the insulator element. In some embodiments, at least the exposure of the resistive path to outer influences and mechanical stresses may be reduced. In some embodiments, the insulator element may protrude from the resistive path in the direction facing away from the substrate. In some embodiments, the insulator thickness may be at least 30% of the thickness of the resistive trace.

The insulator element may protect edges of the resistive path. The insulator element may, alternatively or additionally, protect the top of at least a part of the resistive path against mechanical stresses. Additionally or alternatively, an insulator element of the invention may improve the electrical insulation relative to the resistive path. This may reduce related degradations and resistance drifts. This may, in turn, lead to improved accuracy and reliability, allowing for higher operating voltage and, at the same time, a smaller size of the resistor structure and voltage divider.

Accordingly, the accuracy and the voltage withstand of the resistor structure and of the corresponding voltage divider arrangement may be enhanced.

Resistive materials commonly employed in thick film technology are based on formulations mainly comprising glass, particles of conductive oxide ceramic such as ruthenium oxide, and possibly other additives such as metal particles. Thick film resistive materials or films have a resistivity (sheet resistance) usually between 50 mΩ/square and 1 GΩ/square.

In the context of the invention, a resistive trace of the resistive path is made of a resistive material with resistivity preferably between 50 Ω/square and 100 MΩ/square, or preferably between 500 Ω/square and 10 MΩ/square. Non-exhaustive examples of possible resistive materials are the R8700 Series from Heraeus or the 2000 Series from DuPont.

Electrically conductive materials commonly employed in thick film technology are based on formulations comprising a major amount of metal particles like Ag, Pd, Au, Pt and possibly other additives. Thick film conductor materials or films have a resistivity usually comprised between 1 mΩ/square and 1 Ω/square. Non-exhaustive examples of possible conductive materials are the C2210 from Heraeus or the 7484 from DuPont.

An insulator material is seen as having a volume resistivity larger than 10⁷ Ω·cm.

The resistive path comprises one or more resistive traces. If more resistive traces are provided, the resistive traces may be connected directly or indirectly and at least partly in series or in parallel.

Optionally, the resistive path comprises resistive traces which are electrically connected in series by transition elements to form the resistive path. Resistive traces may, at least partially, run parallel to each other.

Optionally, according to (b), the insulating coating at least partially covers the resistive path and/or the insulator element. Alternatively, the insulating coating may cover almost the entire substrate.

Optionally, according to (b), the coating is made of the same material as the insulator element and/or wherein the thickness of the coating varies less than about 10% among the coating or is substantially uniform.

Optionally, the insulator element comprises a number of insulator element parts, which are optionally distanced from each other, and/or have substantially the same geometry as the at least one resistive trace of the resistive path, wherein further optionally each insulator part is in the form of preferably parallel stripes. Such realizations allow for efficient manufacture.

Optionally, at least one insulator element is positioned alongside at least a part of the resistive path, optionally running in parallel to at least a part of the resistive trace. This allows for effective protection of the resistive path by way of the insulator element.

Optionally, at least one insulator element is positioned perpendicular to a part of the resistive path, optionally at a turnaround, corner or termination of the resistive path, further optionally outside the resistive path. Such arrangement provides for effective protection of the insulator element at sensitive regions of the resistive path.

Optionally, at least a part of a resistive trace is sandwiched between two insulator elements. This means that the part of the resistive trace is bordered at each lateral side by an insulator element. Protection from two sides, in particular from opposite sides, allows for effective protection of the resistive path.

Optionally, an edge part of the resistive trace and a part of the insulator element overlap in the thickness direction. Further optionally, the insulator element at least partially overlaps the edge of the resistive path, so as to cover and protect the edge.

Optionally, a distance between the resistive trace and the insulator element is less than 25% of the width of the resistive trace and/or less than 150 µm. Providing the insulator element relatively closely to the resistive path may improve the protection.

Optionally, the insulator element is made of an inorganic insulating material comprising glass or ceramics and/or has a denser structure (less or thinner grain boundaries and/or smaller voids) than the insulating substrate. This may allow for improved dielectric strength of the insulator element.

The width of the insulator element (part) may be approximately equal to or preferably smaller than that of a resistive trace. This may allow to exploit more efficiently the benefits of an insulator element, for example by reducing the useage of other matrials employed for manufacturing the resistor structure.

Optionally, the dielectric strength of the insulator element is higher than the dielectric strength of the insulating substrate and/or the dielectric constant and/or the coefficient of thermal expansion of the insulator element is substantially the same as of the insulating substrate. This mayimprove the dielectric strength and the reliability of the resistor structure.

Optionally, the insulator element is a film, optionally a stack of films. One or more films allow for efficient application and integration into the manufacturing process.

Optionally, the insulator element is deposited by screen printing or direct printing through a nozzle, before or after deposition of the resistive path. This supports efficient manufacture.

Optionally, the insulator element is provided next to a junction element connecting the terminal, and/or next to an interconnecting element connecting at least two resistive traces of the resistive path and a portion of the terminal, and/or next to an interconnecting path connecting at least an end of a first resistive path and an end of a second resistive path and the portion of the terminal, wherein the resistive path comprises at least the first and second resistive paths. These locations may render the protection by way of an insulation element more effective.

Resistor structures of the invention may be manufactured using thick film technology, e.g. screen printing or stencil printing or direct printing through a nozzle. Films of conductive material and of resistive material are sequentially deposited on an insulating substrate. Typically, a single layer of a single material is deposited, followed by a subsequent step such as drying or firing. For example, conductive film or a resistive film are fired at a very high temperature, between 600°C and 950°C.

The insulating substrate may be made of ceramic material, such as aluminum oxide or aluminum nitride. The insulating substrate may be in the form of a flat, planar sheet or, alternatively, in the form of a cylinder.

In addition to the first electrically conductive terminal, at least a second electrically conductive terminal may be typically provided in a resistive structure, wherein the resistive path connects to the first and second terminals. In a voltage divider, the high and low-ohmic resistors may share a terminal, so that a voltage divider arrangement may comprise at least first, second and third terminals.

The resistive path may comprise, in addition to the at least first resistive path, a second resistive path, wherein the paths are connected in series. A resistive path (or the resistive paths) may at least partially be in the form of a helix. Hence, the resistive path may at least partially run helically.

A coating made of an electrically insulating material may be provided. In some embodiments, the coating may be the outermost entity or layer. The coating may cover the entire resistive structure or partially. The coating may cover at least part of the resistive path and possibly part(s) of the terminal(s). A part of each terminal is preferably not covered by the coating in order to provide electrical connection(s) to the resistive structure. The coating may be a film and may be made of a thickness between 5 to 100 µm and/or between 3 to 30 µm. The coating film may have different thicknesses, optionally a first thickness being between 5 and 100 µm, and a second thickness being between 3 and 30 µm, where the first thickness is larger than the second thickness by at least 50% or at least 5 µm.

Optionally, a second coating, e.g. made of a polymer, may be applied on a first coating. The second coating may be thicker than the first coating.

A shunt may be provided. A shunt section is configured to shunt a distinct portion of a resistive trace to proportionally reduce its effective resistive length. This may mean that the length which is electrically effective (and, thus, determines the electrical resistance of the trace ) is shorter than the actual length of the trace. A transition element may shunt section. A shunt section has a lower resistivity than the resistive trace to which the shunt section (e.g. transition element) is connected to.

Optionally, the resistor structure comprises resistive traces being mainly identical and being preferably arranged periodically with mainly a same pitch. The resistive traces may be made of a same resistive material, and may have mainly a same thickness, width, slope, and (actual) length. This helps for efficient and reproducible manufacturing of the resistive traces and of the resistive path.

A voltage divider arrangement of the invention may comprise a high ohmic resistor and a low ohmic resistor electrically connected in series, where the voltage divider arrangement comprises at least one resistor structure of the invention. The high ohmic resistor is made of one or more resistive traces and the low ohmic resistor is made of one or more resistive traces, and the high ohmic and the low ohmic resistors differ as to their resistance.

Optionally, the voltage divider arrangement is provided on the same substrate and comprises resistive traces being substantially identical, and insulator elements being substantially identical, wherein preferably the resistive traces and the insulator elements are arranged substantially in a periodic manner. This may provide an arrangement which is more effective to manufacture and less prone to failure.

An electrical device of the invention comprises a resistor structure or a voltage divider arrangement of the invention.

### Brief description of the drawings

Figure 1 shows a schematic plan view of a resistor structure of the invention.
Figure 2 shows a top view of a plan resistor structure the invention.
Figure 3 shows cross-sectional views of a resistor structure of the invention, wherein figures 3(a) to (d) show different embodiments.
Figure 4 shows a cross-sectional view of another resistor structure of the invention.
Figure 5 shows cross-sectional views of resistor structures of the invention, wherein figures 5(a) and (b) refer to different embodiments.
Figure 6 shows a voltage divider arrangement in a plan view.
Figure 7 shows a voltage divider arrangement having a cylindrical substrate in perspective views, wherein figures 7(a) and (b) show views from different angles.

### Detailed description of embodiments

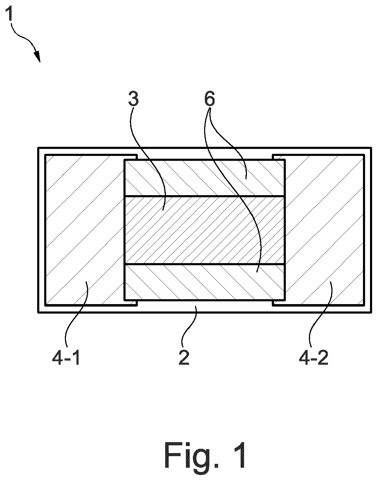

Figure 1 schematically shows a resistor structure 1 having first 4-1 and second 4-2 terminals. The terminals are provided on a substrate 2. Further, a resistive path 3 is applied onto the substrate 2. The resistive path 3 runs between the first 4-1 and second 4-2 terminals. An insulator element 6 having two parts in the embodiment of figure 1 is located next, i.e. adjacent or neighbored, to the resistive path 3. As shown in this example, the insulator element 6 may laterally sandwich at least a part of the resistive path 3, so as to improve the protection of the resistive path 3 by the insulator element 6.

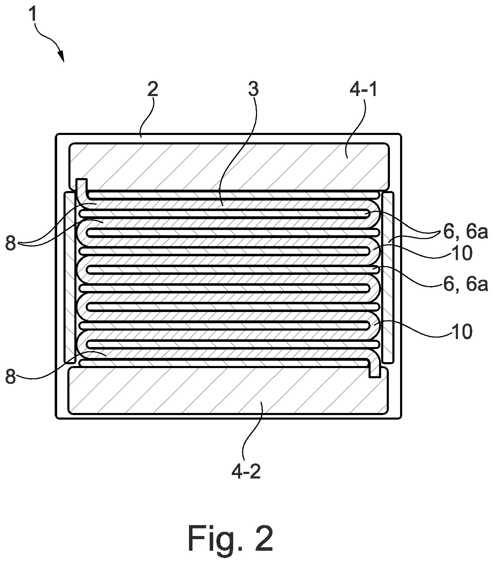

Figure 2 shows a plan resistor structure 1 and details as to the resistive path 3 and the insulator element 6. Specifically, the resistive path 3 comprises at least one resistive trace 8 forming turnarounds 10. Various parts 6a of the insulator element 6 are shown in the embodiment of figure 2. More specifically, the parts 6a of the insulator element are distanced from each other. The insulator elements 6a may have the same geometry, namely stripes in the embodiment of figure 2. These stripes run parallel to each other and parallel to the resistive traces 8. Each resistive trace 8 may be seen as laterally sandwiched between two insulator elements 6. Further insulator element parts 6a, also in the form of stripes, are positioned perpendicular to the run of the resistive traces 8 positioned adjacent to the turnarounds 10. These parts 6a are provided outside the resistive path 3 and embrace the entire resistive path 3 inbetween.

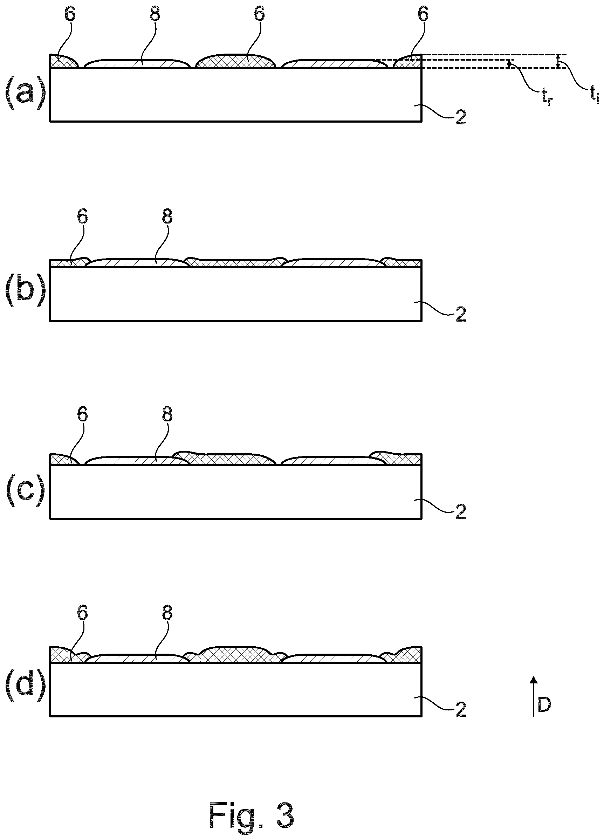

Figure 3 shows embodiments of a resistor structure 1 of the invention, wherein the resistive trace 8 as well as most of the remaining resistor structure 1 is free of any coating. The thickness is indicated with respect to the thickness direction D, namely the direction which faces away from the substrate 2. The thickness tᵢ of the insulator element 6 is at least 30% of the thickness t, of the resistive trace 8. In figure 3(a), for example, the thickness tᵢ of the insulating element 6 is larger than the thickness t, of the resistive trace 8. In figure 3(b), the insulator element 6 has a thickness tᵢ which is larger than the thickness tᵣ of the resistive trace, wherein the edges of the resistive trace 8 are overlapped by the insulator element 6. As shown in figure 3(c), at one edge of the resistive trace 8, the insulator element 6 overlaps the resistive trace 8. A part of the resistive path 3 and a part of the insulator element 6, accordingly, overlap in the thickness direction D. On the opposite edge of the resistive trace 8 in the width direction of the resistive trace 8, there is no overlap between the insulator element 6 and the resistive trace 8. Rather, in figure 3(c), a gap can be identified. A distance between the resistive trace 8 and the adjacent insulator element 6 may be less than 25% of the width of the resistive trace 8 and/or less than 150 µm. Figure 3(d) shows an embodiment in which the insulator element 6 is thicker than the resistive trace 8, wherein the insulator element 6 has indentations near the overlap with the resistive trace 8.

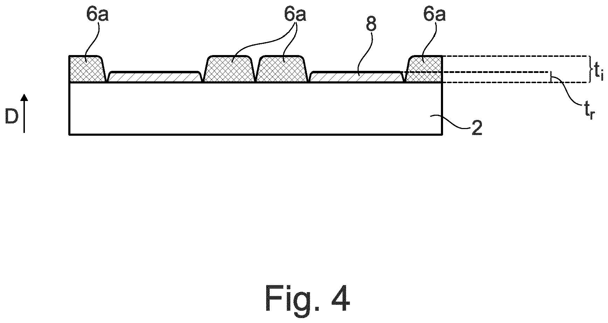

Figure 4 shows an embodiment in which two insulator elements 6a next to each other together form an insulator element 6. A number of insulator elements 6a may form the insulator element 6. In this example, the thickness tᵢ of the insulator element 6 is larger than the thickness t, of the resistive trace 8.

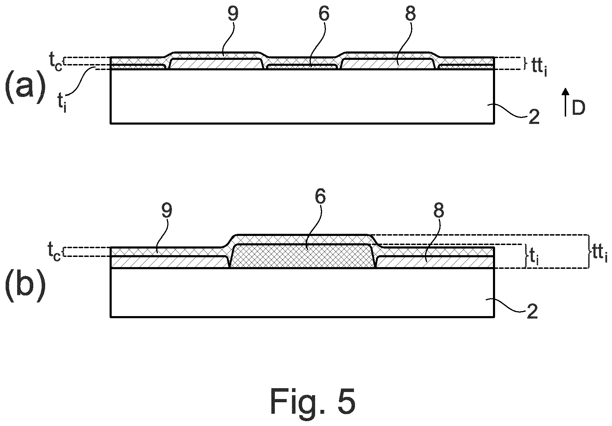

Figure 5 shows embodiments having a coating 9. The coating 9 is provided on top of the insulator element 6 and the (most of the) remaining resistor structure 1. The coating 9 has a thickness between 1 µm and 200 µm and is substantially uniform. The thickness t_{c} of the coating 9 varies less than about 10% among the coating 9. As shown in figure 5(a), the coating is provided on top of the resistive traces 8 and the neighbored insulator element 6. The insulator element 6 is below the coating 9 and may be regarded as "buried" or "hidden" underneath the coating 9. The insulator element 6 may no longer be discernible from the coating 9. What remains discernible may be the total thickness of the combination of the coating 9 and of the insulator element 6 in the thickness direction D. The thickness ttᵢ of the coating 9 plus the thickness of the insulator element 6 in total corresponds at least to the thickness of the insulation next to the resistive trace 8. This total thickness ttᵢ exceeds the thickness t_{c} of the insulating coating 9 on top of the resistive trace 8. On top of the resistive trace 8, only the insulating coating 9, but no insulator element 6 of the invention is provided. The insulator element 6 can, accordingly, e.g. contribute to a levelling of the overall surface by reducing the difference in height between parts of the coating 9 under which a resistive trace 8 is formed and under which no resistive trace 8 is formed.

Figure 5(b) shows an embodiment in which the thickness tᵢ of the insulator element 6 exceeds the thickness tᵣ of the resistive trace 8. Also, the total thickness ttᵢ of the combination of the insulator element 6 and of the insulating coating 9 exceeds the thickness t_{c} of the insulating coating 9 on the resistive trace 8 by at least 30%, here by about 300%. In this embodiment, as the height/thickness of the insulator element 6 exceeds the height/thickness of the resistive trace 8, the resistive trace 8 is protected by the insulator element 6 protruding from the remaining substrate 2.

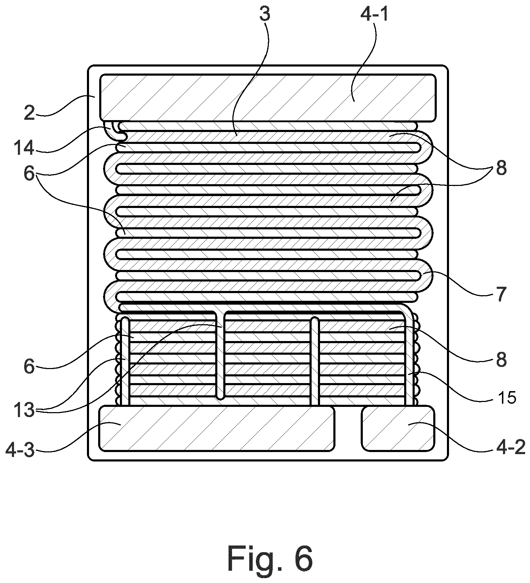

Figure 6 shows a voltage divider arrangement 5 having a flat substrate 2. An insulator element 6 is provided next to a junction element 14 which connects the beginning of the resistive path 3 with the first terminal 4-1. Further, next to an interconnecting element 13 which connects a plurality of resistive traces 8 to the terminal, here to the third terminal 4-3, an insulator element 6 is provided. The insulator elements 6 basically run perpendicular to the interconnecting element 13. Further, next to an interconnecting path 15 connecting at least an end of a first resistive path 3-1 and a second resistive path 3-2 and a terminal, here the second terminal 4-2, insulator elements 6 are provided. These insulator elements 6 run at least partially parallel to the interconnecting path 15 and at least partially perpendicular to the interconnecting path 15. All insulator elements 6 of the voltage divider arrangement 5 may be identical and positioned parallel to each other.

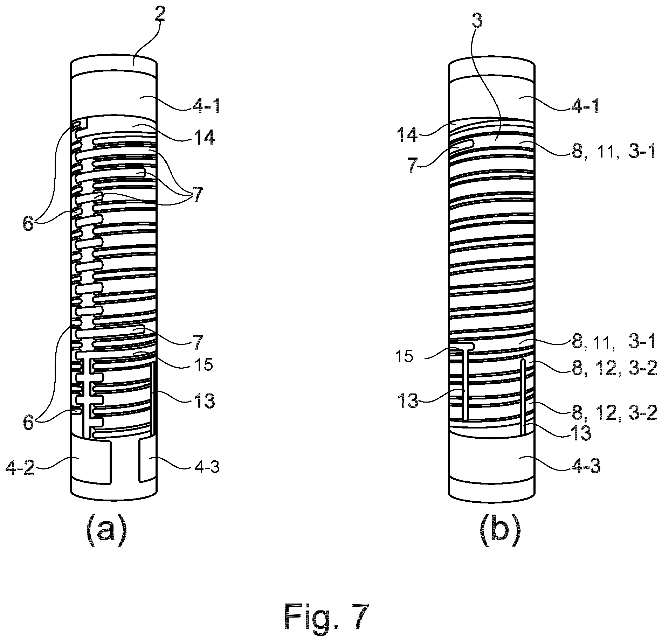

Figure 7 shows a voltage divider arrangement 5 with a cylindrical substrate 2 and a helix-shaped resistive path 3. The path 3 comprises a first resistive path 3-1 of a highohmic resistor 11, and a second resistive path 3-2 of a low-ohmic resistor 12, which are connected in series. The first terminal 4-1 is located opposite to the second 4-2 and third 4-3 terminals. Figure 7 further shows a junction element 14 for connecting a trace 8 and the first terminal 4-1, and transition elements 7 connecting two subsequent resistive traces 8 with each other.

In the embodiments shown in figures 1 to 4, no coating is provided. Also, the embodiments of figure 6 and 7 are free of coating. However, in the embodiment of figure 5, the coating 9 is present. To any of the embodiments of the invention, a coating 9 of the invention may be added. Also, it is conceivable that a so-called conformal coating having a thickness of about 1 mm may be added. A coating 9 may be an insulating coating having a thickness of about 1 to 200 µm, preferably 1 to 100 µm. Hence, a conformal coating differs from the coating 9 of the invention. The coating 9 may be made of an insulating material and of the same material as the insulator element 6 of the invention. It is possible that, in the final product, the coating 9 and an insulator element 6 of the invention are hardly discernible or are not discernible.

In any of the embodiments, the insulator element 6 may be a film. Optionally, the insulator element 6 may be formed by a stack of a plurality of films which are provided on top of each other.

Any insulator element 6 of the invention may be made of an inorganic insulating material. The dielectric strength of the insulator element 6 is typically higher than the dielectric strength of the insulating substrate 2 and/or the dielectric constant and/or the coefficient of thermal expansion of the insulator element 6 is substantially the same as of the insulating substrate 2. A resistor structure 1 of the invention may be deposited by screen printing. This can be done before or after deposition of the resistive traces 8.

### Reference signs

1 resistor/resistive structure
2 electrically insulating substrate
3 resistive path
3-1 first resistive path
4 terminal
4-1 first terminal
4-2 second terminal
4-3 third terminal
6 insulator element
6a part of insulator element
7 transition element
8 resistive trace
9 coating
10 turnaround of resistive path
11 high ohmic resistor
12 low ohmic resistor
13 interconnecting element
14 junction element
15 interconnecting path
tᵢ thickness of insulator element
t, thickness of resistive trace
ttᵢ total thickness of insulation on top of substrate
t_{c} thickness of coating
D thickness direction

## Claims

1. Resistor structure (1) comprising at least
an electrically insulating substrate (2),
at least one electrically conductive terminal (4) directly or indirectly provided on the substrate (2),
at least one resistive path (3) comprising at least one resistive trace (8) directly or indirectly provided on the substrate (2) and directly or indirectly joined to the terminal (4), wherein a thickness (tr) of the resistive trace (8) is the thickness of the resistive trace (8) in the thickness direction (D) facing away from the substrate (2), **characterized in that**
at least one insulator element (6) is applied directly or indirectly and at least partially on the substrate (2), wherein a thickness (ti) of the insulator element is the thickness of the insulator element in the thickness direction (D) facing away from the substrate (2), and **in that**
at least a part of the insulator element (6) and a part of the resistive path (3) are arranged at least partially adjacent to each other and such that
(a) if the resistive trace (8) is substantially free of a coating (9) of a thickness (tc) between 1 µm and 200 µm, preferably 1 and 100 µm, optionally substantially free of any coating, the thickness (ti) of the insulator element is at least 30% of the thickness (tr) of the resistive trace (8), optionally larger than the thickness (tr) of the resistive trace (8),
and/or
(b) if the resistive trace (8) is substantially covered by an insulating coating (9) having a thickness (tc) between 1 µm and 200 µm, preferably 1 and 100 µm, a total thickness (tti) of the insulator element and of the insulating coating exceeds the thickness (tc) of the insulating coating (9) on the resistive trace (8), optionally by at least 30%.

2. Resistor structure of claim 1, wherein, according to (b), the insulating coating (9) at least partially covers the resistive path (3) and/or the insulator element (6) and/or is selectively applied.

3. Resistor structure of claim 2, wherein, according to (b), the coating (9) is made of the same material as the insulator element (6).

4. Resistor structure of any of the preceding claims, wherein the insulator element (6) comprises a number of insulator element parts (6a), which are optionally distanced from each other, and/or has substantially the same geometry as at least one resistive trace (8) of the resistive path (3), wherein further optionally each insulator part (6a) is in the form of preferably parallel stripes.

5. Resistor structure of any of the preceding claims, wherein at least one insulator element (6) is positioned alongside at least a part of the resistive path (3), optionally running in parallel to at least a part of the resistive trace (8).

6. Resistor structure of any of the preceding claims, wherein the resistive path is at least partly shaped like a helix and the insulator element is at least partially provided between turns of the resistive path and/or the insulator element is at least partly shaped like a helix.

7. Resistor structure of any of the preceding claims, wherein at least a part of a resistive trace (8) is sandwiched between two insulator elements (6), when viewed along a surface parallel to the substrate (2).

8. Resistor structure of any of the preceding claims, wherein an edge of the resistive trace (8) and a part of the insulator element (6) overlap in the thickness direction (D).

9. Resistor structure of any of the preceding claims, wherein at least in part a distance between the resistive trace (8) and the insulator element (6) is less than 25% of the width of the resistive trace (8) and/or less than 150 µm.

10. Resistor structure of any of the preceding claims, wherein the insulator element (6) is made of an inorganic insulating material comprising glass.

11. Resistor structure of any of the preceding claims, wherein insulator element parts (6a) are interposed between resistive traces (8) and preferably between a resistive trace (8) and the terminal (4), where the insulator element part (6a) and the resistive trace (8) have preferably approximately equal length and slope.

12. Resistor structure of any of the preceding claims, wherein the insulator element (6) is a film, optionally a stack of films.

13. Resistor structure of any of the preceding claims, wherein the insulator element (6) is deposited by screen printing, before or after deposition of the resistive path (3).

14. Resistor structure of any of the preceding claims, wherein the insulator element (6) is provided next to a junction element (14) connecting the terminal,
and/or
next to an interconnecting element (13) connecting at least two resistive traces (8) of the resistive path (3) and a portion of the terminal (4-2),
and/or
next to an interconnecting path (15) connecting at least an end of a first resistive path (3-1) and an end of a second resistive path (3-2) and the portion of the terminal (4-2), wherein the resistive path (3) comprises at least the first (3-1) and second (3-2) resistive paths.

15. Voltage divider arrangement (5) for electrical power systems for transformation of voltage, the voltage divider arrangement comprising a first resistor structure (1) of any of the preceding claims, and a second resistor structure (1), optionally of any of the preceding claims, wherein the first and second resistor structures are connected in series and the first and second resistor structures differs as to their resistance.

16. Voltage divider arrangement of claim 15, which is provided on the same substrate (2) and comprises resistive traces (8) being substantially identical and substantially insulator elements being substantially identical, wherein preferably the resistive traces (8) and the insulator elements (6) are arranged substantially in a periodic manner.

17. Electrical device comprising the resistor structure (1) and/or the voltage divider arrangement (5) of any of the preceding claims.
